# EUROPÄISCHE PATENTANMELDUNG

(11) **EP 2 908 083 A1**
(43) Veröffentlichungstag der Anmeldung: **19.08.2015**
(21) Anmeldenummer: 14155030.1
(22) Anmeldetag: 13.02.2014
(51) Int. Cl.: F28F 21/00, F28F 21/02, H01L 23/373, C03B 19/06, C04B 35/00

(54) **Verwendung eines Materials umfassend eine verpresste Mischung von Graphit und Glas zur Kühlung**

(71) Anmelder: Ald Vacuum Technologies GmbH, 63450 Hanau (DE)
(72) Erfinder: Fachinger, Johannes, Dr., 41068 Mönchengladbach (DE); Grosse, Karl-Heinz, 63584 Gründau (DE)
(74) Vertreter: Fuchs Patentanwälte Partnerschaft mbB

(57) **Zusammenfassung**

Die vorliegende Erfindung betrifft die Verwendung eines Materials, umfassend Graphit und Glas als verpresste Mischung, als Bauteil eines Reaktionsreaktors, insbesondere als Wärmetauscher oder zur Kühlung von anderen Bauteilen, insbesondere auch elektronischen Bauteilen. Die Erfindung betrifft auch ein Verfahren zur endkonturnahen Herstellung eines Formkörpers. Der Formkörper kann insbesondere ein Reaktionsreaktor, ein Bauteil für einen Reaktionsreaktor, ein Wärmetauschers oder Kühlkörper sein. Der Formkörper besteht aus dem Material, das Glas und Graphit als verpresste Mischung umfasst.

## Beschreibung

Die vorliegende Erfindung betrifft die Verwendung eines Materials, umfassend Graphit und Glas als verpresste Mischung, als Bauteil eines Reaktionsreaktors, insbesondere als Wärmetauscher oder zur Kühlung von anderen Bauteilen, insbesondere auch elektronischen Bauteilen. Die Erfindung betrifft auch ein Verfahren zur endkonturnahen Herstellung eines Formkörpers. Der Formkörper kann insbesondere ein Reaktionsreaktor, ein Bauteil für einen Reaktionsreaktor, ein Wärmetauschers oder Kühlkörper sein. Der Formkörper besteht aus dem Material, das Glas und Graphit als verpresste Mischung umfasst.

Derzeit werden in der chemischen Industrie Graphite als Reaktionsreaktoren und auch als Wärmetauscher oder zur Kühlung eingesetzt. Dies ist vermehrt der Fall sofern aggressive Medien in ein Verfahren oder eine Reaktion involviert sind, da Graphite chemisch inert sind. Die Graphite müssen aber auch für Reaktionsmedien, insbesondere für aggressive Medien, undurchlässig sein. Undurchlässigkeit muss auch gewährleistet sein sofern Reaktionen bei erhörten Temperaturen durchgeführt werden.

Sind Gase in das Reaktionsgeschehen involviert, so müssen sämtliche Bauteile von Reaktionsreaktoren und/oder Wärmetauschern und/oder Kühlkörpern auch für entsprechende Gase undurchlässig sein.

Die Anforderungen an das Material, aus dem Reaktionsreaktoren und/oder Wärmetauscher und/oder Kühlkörper bestehen, steigen wenn Reaktionen bei erhöhten Temperaturen und/oder Drucken stattfinden. Sind Druck und Temperatur erhöht und dazu möglicherweise noch Gase im Reaktionsgemisch, gelten höchste Anforderungen an alle Bauteile von Reaktionsreaktoren und auch an Wärmetauscher oder Kühlkörper, da diese auch unter diesen Bedingungen undurchlässig sein sollen.

Deshalb werden Graphite, die aus dem Stand der Technik bekannt sind, durch Imprägnierung mit organischen Harzen undurchlässig gemacht. Jedoch sind organische Verbindungen, insbesondere Harze, bei hohen Temperaturen nicht stabil und zersetzten sich. Als Folge werden die imprägnierten Graphite durchlässig und damit undicht und entsprechende Apparaturen müssen ersetzt werden. Die Standzeiten sind kurz und die Kosten folglich hoch.

Die DE 33 19 296 C2 beschreibt, dass mit Harz imprägnierte Graphite mechanisch nicht ausreichend belastbar sind. Zug- Biege- und Druckfestigkeit solcher Materialien sind nicht ausreichend für, beispielsweise, den Einsatz als Wärmetauscher. Ferner sind solche Materialien anfällig für Abrasion und Erosion. Gemäß der DE 33 19 296 C2 wird vorgeschlagen, mit Harzen imprägnierte Graphite als Basismaterial zu verwenden und diese mit Fasern, die selbst wiederum mit Harzen imprägniert sind, als Verbundwerkstoff auszubilden. Dabei sollen der imprägnierte Graphit und die imprägnierten Fasern möglichst innig miteinander verbunden sein. Die Fasern können aus Glas bestehen.

Es liegt auf der Hand, dass das Herstellen eines solchen Verbundwerkstoffs aufwändig ist, dass eine porenfreie Verbindung zwischen den Fasern und des imprägnierten Basisgraphits nicht möglich ist und dass ferner sowohl für die imprägnierten Fasern als auch für den imprägnierten Graphit die Problematik besteht, dass sich bei hohen Temperaturen die Harze zersetzen.

Die EP 0 270 666 B1 beschäftigt sich mit Kohlenstofffibrillen eines konstanten Durchmessers mit einer definierten Länge, deren Ausmaße im Nanometerbereich liegen. Auch vorgeschlagen werden Verbundmaterialien, die aus Kohlenstofffibrillen eingebettet in eine Matrix bestehen. Das Matrixmaterial kann gemäß der EP 0 270 666 B1 fast jedwedes Material sein, von pyrolytischem Kohlenstoff bis hin zu einem organischen Polymer, auch keramische Materialien werden genannt und anorganische Polymere, wie Siliziumcarbid oder Glas. Die Verbundmaterialien können die elektrische oder thermische Leitfähigkeit eines Materials verbessern, wobei die beispielsweise als Platte ausgestalteten Verbundmaterialien in die Materialien, deren Leitfähigkeit verbessert werden soll, eingebettet werden.

Es ist bekannt, dass das Herstellen von Kohlenstofffibrillen, auch bekannt als CNTs (carbon nanotubes) aufwändig und kostspielig ist. Werden solche Fibrillen in eine Matrix eingebettet, entsteht - wie in der EP 0 270 666 B1 beschreiben - ein Verbundwerkstoff. Die definierten graphitischen Fibrillen liegen innerhalb eines anderen Werkstoffes als Fibrillen vor. Für den Fall, dass es sich bei dem Matrixmaterial um Glas handelt, werden die Eigenschaften des jeweiligen Glases die Eigenschaften des Verbundwerkstoffes maßgeblich bestimmen. Homogenität von Glas und Graphit und damit verbundene hohe Dichte im Sinne von Porenfreiheit kann mit einem solchen Verbundwerkstoff nicht erreicht werden.

Der Betrieb von elektronischen Bauteilen kann zu einer erheblichen Wärmeabgabe führen. Um eine Beeinträchtigung der Bauteile durch Überhitzung zu vermeiden, ist es erforderlich, die abgegebene Wärme möglichst zügig abzuführen. Elektronische Bauteile werden häufig mittels metallischer Wärmeleiter gekühlt. Beispielsweise Kupfer kommt zum Einsatz. Konstruktionsbedingt sind die Ausmaße, die bei der Kühlung von Elektronikteilen einhergehen, häufig zu groß für Anwendungen in superflachen Rechnern, wie Tablet-PCs und Laptops. Es besteht ein ständiges Bestreben zur Miniaturisierung, auch bei den Kühlkörpern. Ferner spielt das Gewicht des Endgeräts eine große Rolle. Dies wird auch in der EP 1 420 446 A1 problematisiert, was zu einem Lösungsvorschlag führt, wonach auch ein Verbundwerkstoff vorgeschlagen wird. Ähnlich wie oben geschildert ist das Basismaterial oder Verstärkungsmaterial für den Verbundwerkstoff eine Faser, ausgestaltet als Nanofaser oder auch als Faser mit Durchmessern von bis zu 15 µm (Mikrofaser). Die Fasern werden mit einem flüssigen Metall oder einer flüssigen Metalllegierung oder einem nicht ausgehärteten Polymer infiltriert. Nach Aushärten des Materials wird, beispielsweise durch Sputtern, zusätzlich eine metallische Oberfläche aufgebracht. Die Fasern können aus Kohlenstoff sein, wahlweise auch aus keramischen Materialien oder Glas. Letzteres ist daran gebunden, dass die Fasern als Mikrofasern mit Durchmessern von größer als 1 µm ausgebildet sind.

Verbundmaterialien, die drei verschiedene Phasen aufweisen, sind aufwändig in der Herstellung und damit teuer. Alleine die Herstellung der Fasern und das infiltrieren dieser ist umständlich. Das zusätzliche Aufbringen einer metallischen Schicht macht die Herstellung des Verbundwerkstoffes nochmals umständlicher.

Gerade aber Elemente zur Ableitung von Wärme, also Kühlkörper, sollten einfach herstellbar und entsprechend einfach in der Anwendung sein, insbesondere wenn es um die Kühlung von elektronischen Bauteilen geht.

Es besteht Bedarf am graphitischen Werkstoffen oder Materialien, die undurchlässig und chemisch resistent sind, dabei aber gerade nicht mit einem organischen Polymer imprägniert. Es besteht ferner Bedarf an Materialien, die sich als Kühlkörpern für Elektronikbauteile eignen, einfach herzustellen sind, gute Wärmeleitfähigkeit aufweisen und leicht und platzsparend sind. Insbesondere für die Kühlung von Elektronikbauteilen in Laptops, Tablet-PCs und anderen flachen Elektronikgeräten ist ein geringes Volumen und Gewicht für den Kühlkörper wichtig.

Es ist daher die Aufgabe der vorliegenden Erfindung ein Material zur Verwendung als Reaktionsreaktor, Bauteil eines Reaktionsreaktors, Wärmetauscher, insbesondere Kühlkörper für Elektronikbauteile, zu finden. Das Material soll chemisch beständig, undurchlässig, gut wärmeleitfähig und dazu einfach und kostengünstig herstellbar sein. Sofern das Material in einer bestimmten Form vorliegen soll, so soll ein derartiger Formkörper möglichst einfach und kostengünstig endkonturnah herstellbar sein.

Es wurde überraschenderweise gefunden, dass ein an sich bekanntes Material, umfassend Graphit und Glas als verpresste Mischung, alle oben genannten Eigenschaften erfüllt und sich damit zu den allen oben genannten Verwendungen eignet. Das Material kann durch ein erfindungsgemäßes Verfahren endkonturnah zu einem Formkörper ausgeformt werden, welcher Formkörper eine für die jeweilige Verwendung angepasste Form hat.

Die Aufgabe der Erfindung wird demnach durch die in den Patentansprüchen formulierte Verwendung und durch das erfindungsgemäße Verfahren erfüllt.

Das Material umfasst Graphit und Glas als verpresste Mischung. Das Material ist kein Verbundwerkstoff sondern vielmehr ein homogenes Material, entstanden aus Graphit- und Glaspulver. Die Pulver werden homogen gemischt und dann zu dem Material verpresst. Die geschieht bei einem Pressdruck von mindestens 3 kN/cm². Vorzugsweise wird das Pressen im Vakuum bei 20mbar oder weniger durchgeführt. Die Temperatur beim Pressen beträgt mindestens 600 °C und hängt von der Temperatur ab, bei der das Glaspulver schmilzt. Sobald das Glaspulver schmilzt benetzt das Glas den Graphit, was zu den vorteilhaften Eigenschaften des Materials führt, wie hiernach ausführlich beschrieben:
Das Material ist chemisch inert. Dies gilt auch bei hohen Temperaturen von größer 200° C, bevorzugt größer 300° C, weiter bevorzugt größer 400° C und am meisten bevorzugt bis zu 500°C.

Das Material ist impermeabel/undurchlässig. Dies gilt auch bei hohen Temperaturen von größer 200°C, bevorzugt größer 300°C, wetier bevorzugt größer 400°C und am meisten bevorzugt bis zu 500°.

Das Material weist einen geringen Abrieb auf.

Gemäß der vorliegenden Erfindung bedeutet chemisch inert, dass das Material umfassend Graphit und Glas vorzugsweise weder durch NaOH-Lösung noch durch HCl-Lösung mit pH-Werten von größer 13 oder 1 und kleiner 1 reagiert, d.h. auch unter solchen Bedingungen nicht korrodiert oder ausgelaugt wird.

Unter impermeabel wird verstanden, dass das Material wenige Poren bis keine Poren aufweist. Diese Eigenschaft wird über die Dichte definiert. Die Dichte des Materials ist nahe an der theoretischen Dichte. Dichten von größer 2,0 g/cm³, bevorzugt größer 2,1 g/cm³ und weiter bevorzugt größer 2,2 g/cm³ sind geeignete Dichten. Ab diesen Dichten wird das Material als impermeabel bezeichnet.

Die Dichte wird beeinflusst von der Art und Weise der Herstellung des Materials. Die zuvor genannten Dichten werden erreicht bei einem Pressdruck von mehr als 3 kN/cm² und einer Presstemperatur von größer als 600 °C, vorzugsweise größer 800°C, weiter bevorzugt größer 1000 °C. DerDruck beim Pressen beträgt kleiner 20 mbar, bevorzugt kleiner 2 mbar und ganz bevorzugt kleiner 10⁻¹ mbar.

Unter geringem Abrieb wird verstanden, dass der Abrieb des Materials kleiner ist als der Abrieb für reinen Graphit.

Das Material ist, wie zuvor gesagt, ein bekannte und in der Literatur beschriebenes Material, wobei als geeignete Verwendung ausschließlich die Verwendung als Matrixmaterial zur Endlagerung von radioaktiven Abfällen beschrieben wird.

Es sind grundsätzlich alle Arten von Gläsern für das Material geeignet. Der Fachmann ist sich darüber im Klaren, dass beispielsweise die chemische Beständigkeit und andere Eigenschaften des Glases, das als verpresste Mischung mit Graphit vorliegt, die Eigenschaften des Materials beeinflusst. Je nach gewünschter Verwendung wird der Fachmann ein geeignetes Glas auswählen. Beispielhaft und nicht abschließend kann das Glas ausgewählte sein aus einem oder mehreren von: Borosilikatgläsern, Bleigläsern, Phosphatgläsern, Alkali-Gläsern, Erdalkaligläsern, Kalk-Natron-Gläsern.

Der Vorteil, der durch Borosilikatgläser erreicht werden kann, ist eine sehr gute Korrosionsbeständigkeit des Materials. Borosilikatgläser sind sehr korrossionsstabil, haben eine gute chemische Resistenz und hohe Temperaturbeständigkeit. Der thermische Expansionskoeffizient beträgt 3,1 bis 3,4 x10⁻⁶ K-¹. Die Stabilität gegenüber chemischen Substanzen ist hoch ausgeprägt. Beispielsweise ist das Material, das Borosilikatglas als Glas enthält, stabil gegenüber Säuren mit pH-Werten von kleiner als 1 und Laugen mit pH-Werten von größer 13. Ebenfalls ist ein solches Material beständig gegenüber korrodierenden Gasen, wie beispielsweise Chlorgas. Borosilikatgläser weisen typischerweise Viskositäten (ISO 7884-8) von 10^{7,6} dPas bei 1260°C und 10¹³ dPas bei 560°C auf. Somit kann das Material umfassend Grapht und Borosilikatglas Temperaturen bis 500°C völlig problemlos überstehen ohne eine Rissbildung zu zeigen. Gängige Borosilikatgläser sind beispielsweise Jeaner Glas, Duran^{®}, Pyrex^{®}, Ilmabor^{®}, Simax^{®}, Solidex^{®} and Fiolax^{®}. Die Zusammensetzungen sind dem Fachmann bekannt und nur beispielhaft sind die folgenden Zusammensetzungen genannt: Siliziumdioxid 70 bis 75 Gew.-%, Boroxid 7 bis 10,5 Gew.-%, Aluminiumoxid 5 bis 6 Gew.-%, Natriumoxid 6 bis 7 Gew.-%, Kaliumoxid wahlweise bis zu 1 Gew.-%, Bariumoxid wahlweise bis zu 2 Gew.-%, Kalziumoxid von kleiner 1 bis 1,5 Gew.-%, wahlweise bis zu 5 Gew.-% Titanoxid und bis zu 1 Gew.-% Eisenoxid.

Kalk-Natron-Gläser sind ebenfalls bevorzugt für das Material umfassend Glas und Graphit. Kalk-Natron-Glas wird hergestellt, indem Quarzsand, Soda und Kalk bei über 1.200 °C erschmolzen werden. Dabei bidet sich ein Silicatglas, dessen Hauptbestandteile Siliziumdioxid (SiO₂, 71 bis 75 Gew.-%), Natriumoxid (Na₂O, 12 bis 16 Gew.-%) und Calciumoxid (CaO, 10 bis 15 Gew.-%). Daneben können noch weitere Bestandteile enthalten sein.

Wie zuvor gesagt, wird der Fachmann auch weitere Gläser für das Material in Betracht ziehen. Es ist beispielsweise allgemein bekannt, dass Bleigläser hervorragend chemisch resistent sind. Phosphatgläser weisen niedrige Schmelzpunkte auf. Das kann von Vorteil sein bei der Herstellung des Materials durch Heißpressen. Geringere Temperaturen bedeuten Energieeinsparung.

Alkaligläser haben eine geringe Viskosität. Das erhöht deren Eigenschaft, benetzend für Graphit zu sein. Dies ist wünschenswert, weil so perfekt Poren geschlossen werden können und das Material die bevorzugte Dichte erreichen kann.

Erdalkaligläser sind hervorragend säurebeständig, dabei auch noch einfach zu verarbeiten und kostengünstig. Der Fachmann wird solche Eigenschaften berücksichtigen, je nach Anwendung des Materials.

Ein Vorteil des graphit-basierten Materials ist dessen hohe Wärmeleitfähigkeit, hohe Härte und relativ geringe Wärmeausdehnung sowie die außergewöhnlich geringe Rissempfindlichkeit.

Das Glas ist vorzugsweise ein im erweichten bzw. erschmolzenen Zustand Graphit-benetzendes Material, weil sich dadurch die Hohlräume zwischen den Graphit-Partikeln durch Kapillarkräfte bzw. Adhäsionskräfte von selbst schließen können.

Zur Herstellung des Materials werden zunächst Graphit und Glas in Pulverform gemischt. Diese Mischung wird verpresst. Das Verpressen erfolgt unter Druck und im Vakuum. Bevorzugt bei erhöhten Temperaturen.

Gläser bilden im Gegensatz zu herkömmlichen Bindemitteln während der Wärmebehandlung beim Pressen keine gasförmigen Crack-Produkte. Derartige Gase sind hochgradig unerwünscht, da diese zur Porenbildung in dem verpressten Material führen. Gläser durchlaufen keine Umsetzungsprozesse und es entstehen dadurch keine Poren. Das jeweilig verwendete Glas weist des Weiteren den Vorteil auf, dass es Poren, die sich dennoch bilden könnten, verschließt, was zu den hohen Dichten und der guten chemischen Beständigkeit führt.

Auf Grund der hohen Wärmeleitfähigkeit des Materials ist dieses perfekt geeignet, Wärme abzuführen. Diese Eigenschaft ist vorteilhaft bei der Verwendung des Materials als Reaktionsreaktor oder als ein Teil eines Reaktionsreaktors, ferner bei der Verwendung als Wärmetauscher. Insbesondere wenn das Material als Kühlkörper eingesetzt wird, liegt der Vorteil einer guten Wärmeleitfähigkeit auf der Hand. Von besonderer Bedeutung ist die gute Wärmeleitfähigkeit bei der Verwendung als Kühlkörper für elektronische Bauteile.

Die flächenbezogene Korrosionsrate des Materials bei 95°C in einer magnesiumchloridreichen Salzlauge¹ ist geringer als 2x10⁻⁴g/m²d, weiter bevorzugt geringer als 2x10⁻⁵g/m²d und besonders bevorzugt sogar geringer als 2x10^{- 6}g/m²d. Ein Liter Salzlauge zur Messung der Korrosionsrate besteht aus 937,1 g MgCl₂*6H₂O, 0,13 g MgSO₄*7H₂O, 4,13 g NaCl, 1,42 g KCl und 39,68 g CaCl₂*2H₂O gelöst in entionisiertem Wasser. Die Korrosionsrate bei 95°C wird wie folgt bestimmt: Ein Formkörper hergestellt aus dem Material mit den Abmaßen 10*10*10 mm wird in 100 ml Salzlauge, die sich in einem Kunstoffbecherglas befindet, getaucht. Dabei wird der Formkörper an einem Bindfaden so aufgehängt, dass keine der Seitenflächen das Becherglas berührt. Nach 3 Monaten bzw. einem Jahr wird das Gewicht des Formkörpers mit einer Genauigkeit von 0,1 mg bestimmt und über den Gewichtsverlust die flächenbezogene Korrosionsrate bestimmt.
¹ Lauge 2 gemäß "Stellungnahme des Arbeitskreis HAW-Produkte: Korrosionsexperimente an verglasten Abfällen, Salzlösungen zu S/V-Verhältnis; 1986"

Die hervorragende Korrosionsrate steht für die chemische Beständigkeit des Materials und macht das Material besonders geeignet zur Verwendung als Reaktionsreaktor oder als Teil eines solchen Reaktors.

Es ist erfindungsmäßig bevorzugt, dass das Material zu 50 Gew.-% bis 80 Gew.-% Graphit, bevorzugt von 60 bis 85 Gew.-% Graphit und weiter bevorzugt von 65 bis 90 Gew.-% Graphit umfasst. Der Anteil an Glas beträgt 10 Gew.-% bis 35 Gew.-%, bevorzugt 15 Gew.-% bis 40 Gew.-% und weiter bevorzugt 20 Gew.-% bis 50 Gew.-%. Die Dichte des Materials erreicht mindestens 95% des Wertes für die theoretische Dichte. Vorzugsweise wird eine Dichte von mindestens 97%, idealerweise mehr als 99% der theoretischen Dichte erreicht.

Es ist erfindungsmäßig bevorzugt, dass das Material eine offene Porosität von weniger als 5%, weiter bevorzugt weniger als 2% aufweist.

Der Begriff der Dichte bzw. der theoretischen Dichte wird in der vorliegenden Beschreibung als Synonym zu Porenfreiheit des Materials verwendet. Unter der theoretischen Dichte wird die Dichte verstanden, die sich aus z.B. röntgengeografischen Daten (molare Masse, Anzahl Formeleinheiten der Elementzelle, Volumen der Elementzelle) berechnen lässt.

Die hydraulische Leitfähigkeit des Materials in der vorliegenden Erfindung soll <1x10⁻⁹ m²/sek. betragen.

Der Begriff der Porosität ist eine physikalische Größe und stellt das Verhältnis von Hohlraumvolumen zu Gesamtvolumen eines Stoffes oder Stoffgemisches dar. Die Porosität dient als klassifiziertes Maß für die tatsächlichen vorliegenden Hohlräume.

Es ist bevorzugt, dass der Graphit in dem Material aus zu 20 Gew.-% bis 100 Gew.-% Naturgraphit und aus zu 0 Gew.-% bis 80 Gew.-% synthetischem Graphit besteht.

Weiter bevorzugt ist, dass die Graphitmischung in dem Material zu 60 bis 100 Gew.-% aus Naturgraphit und zu 0 bis 40 Gew.-% aus synthetischem Graphit besteht. Der synthetische Graphit kann auch als graphitiertes Elektropulver (Elektrographit) bezeichnet werden.

Naturgraphit hat den Vorteil, dass er preisgünstig ist, das Graphitkorn im Gegensatz zu synthetischem Graphit keine Mikrorisse aufweist und sich zusätzlich beispielsweise leicht zu Formkörpern mit nahezu theoretischer Dichte verpressen lässt.

Vor dem Verpressen kann dem Material, das zu diesem Zeitpunkt aus einer Mischung von Graphit- und Glaspulver besteht, zusätzlich Kohle und/oder Graphit in der Form von Fasern beigemischt werden.

Dem Material kann vor dem Verpressen optional ein Presshilfsmittel beigemischt werden.

Dabei sind folgende Zusammensetzungen der Materialien vorgesehen:

| Naturgraphit [Gew.-%] | Synt. Graphit [Gew.-%] | anorganischer Binder [ Gew.-%] | Presshilfsmittel |
|---|---|---|---|
| 70-90 | | 30-10 | Nein |
| 0-70 | 80-10 | 10-30 | Nein |
| | 70-90 | 30-10 | Ja |
| 70-90 | | 30-10 | Ja |
| 0-70 | 80-10 | 10-30 | Ja |

Als Presshilfsmittel sind bei höherer Temperatur in Vakuum flüchtige Wachse oder höhermolekulare Alkohole vorgesehen, die eine ausreichende Grünkörperstabilität ermöglichen aber beim Pressvorgang vollständig aus dem Formkörper entfernt werden, so dass ihr Anteil nicht zu den Materialbestandteilen hinzugerechnet werden muss.

Die Herstellung der finalen Formkörper aus dem Material erfolgt beispielsweise durch kaltisostatisches Pressen der Mischung aus Graphit- und Glaspulver, gefolgt von einem Vakuumsinterprozess. Gegebenenfalls kann sich isostatisches Verdichten anschließen. Hierbei kann ein hoher Inertgasdruck notwendig werden. Vorzugsweise erfolgt die Herstellung des Material aus Graphit- und Glaspulver durch heißisostatisches Pressen oder mittels Heißpressen im Vakuum. Alle Verfahren eignen sich zur endkonturnahen Herstellung der gewünschten Endprodukte aus dem Material umfassend Graphit und Glas. Die Pressformen bestehen beispielsweise aus Graphit und sind Negative des gewünschten Formkörpers.

Für alle Herstellungsverfahren wird eine homogenisierte Mischung der Materialkomponenten in Pulverform eingesetzt, wobei eine zusätzliche Vorverdichtung des Materials in Form eines Granulats von Vorteil für das Pressen des Formkörpers sein kann.

### Herstellungsbeispiel eines Formköpers aus einem Glas-Graphitgemisch

### Beispiel 1:

Naturgraphit mit einer mittleren Partikelgröße von ca. 30µm wurde mit 20% Borosilikatglas (Fa. Schott, Glasnummer 8250) mit einer mittleren Partikelgröße von ca. 30µm zu einem homogenen Pulver vermischt. Diese Pulvermischung wurde in einem Kompaktor (Pharmapaktor^{®} L 200/50 P der Fa. Hosokawa Bepex) vorverdichtet. Der Pharmapaktor ist mit Brikettierwalzen mit den Brikettformabmessungen 11 x 11 mm und einer zylindrisch/konischen Vorverdichterschnecke ausgerüstet. Das Brikettgewicht der so hergestellten Pellets lag bei ca. 0,7 g bei einer Brikettdichte von 1,64 g/cm³. Anschließend wurden die Pellets in einer Siebmühle granuliert. In der Siebmühle ist ein Siebeinsatz mit der Maschenweite 3,15 mm eingebaut. Nach der Zerkleinerung ergaben sich etwa folgende Schüttgewichte:

| | |
|---|---|
| Granulat: | 0,8 bis 3,15 mm → 986 g/l |
| | 0 bis 3,15 mm → 1.030 g/l |

Die Granulatausbeute betrug dabei 49%.

Das so hergestellte Granulat wurde anschließend in einer Heißpresse im Vakuum (p_{abs} < 10 mbar) bei einer Temperatur ca. 1050°C mit einer Presskraft von 200kN verdichtet.

Der so hergestellte Formkörper war rund und hatte einen Durchmesser von ca. 60 mm und eine Höhe von ca. 5 mm. Die Dichte des Formkörpers beträgt 2.21 g/cm³ und liegt somit nahe an der theoretischen Dichte von Graphit-Einkristall mit 2.26 g/cm³ was mit einer nahezu porenfreien Struktur gleichzusetzen ist. Von dem Formkörper wurden Schliffproben hergestellt, die sowohl unter Betrachtung im optischen Mikroskop als auch im Rasterelektronenmikroskop keine erkennbaren Poren aufwiesen.

### Materialkenndaten:

| | |
|---|---|
| Druckfestigkeit: 52 - 71 N/mm² | |
| Rockwellhärte HR15Y: | ∥ 92,2 |
| | ⊥ 87,8 |
| Spez. elek. Wiederstand: | ∥ 3,1±0.2·10-5 Ωm |
| | ⊥ 1,8±0.2·10-5 Ωm |

Eine Untersuchung mittels Quecksilberporosimetrie ergab keine offene Makro- oder Mikroporosität. Auch Aufnahmen mit dem Rasterelektronenmikroskop geben keinerlei Hinweise auf das Vorhandensein von Poren.

### Beispiel 2:

Eine Mischung aus einem Teil synthetischem Graphit (Graptech Grade CS) und vier Teilen Naturgraphit mit mittleren Partikelgrößen von ca. 30 µm wurde mit 20% Borosilikatglas mit einer mittleren Partikelgröße von ca. 300 µm zu einem homogenen Pulver vermischt und wie im Beispiel 1 vorverdichtet und granuliert. Granulat: 0,8 - 3,15 mm → 932 g/l bzw. 0-3,15mm → 954 g/l

Die Granulatausbeute betrug dabei 49%.

Das so hergestellte Granulat wurde anschließend in einer Heißpresse im Vakuum (P_{abs} ∼ 250 mbar) bei einer Temperatur ca. 1250°C mit eher Presskraft von 200 kN verdichtet.

Der so hergestellte Formkörper war rund und hatte einen Durchmesser von ca. 60 mm und eine Höhe von ca. 5 mm. Die Dichte des Formkörpers beträgt 2.13 g/cm³ und zeigt somit eine geringfügig geringere Dichte als der Formkörper im Beispiel 1. Dennoch ist ein Graphitformkörper mit einer solchen Dichte ebenfalls mit einer nahezu porenfreien Struktur gleichzusetzen. Mit der Untersuchung von Schliffbildern mittels optischer Mikroskopie kann die Verwendung der gröberen Glaspartikel als Ursache für die geringere Dichte identifiziert werden.

### Anwendungsbeispiele

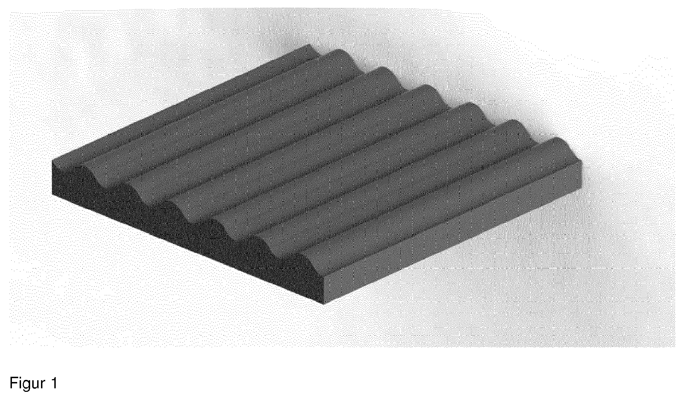

Kühlkörper: Figur 1 zeigt einen Kühlkörper in Plattenform mit gewellter Oberfläche aus dem Material umfassend Graphit und Glas in verpresster Form. Eine solche Struktur eignet sich als Kühlkörper für elektronische Bauteile, wie Chips. Dabei kann die Form dem Bauteil angepasst werden. Beispielsweise kann der Kühlkörper auch rund oder oval oder in anderen beliebigen Formen anders als rechteckig ausgestaltet sein.

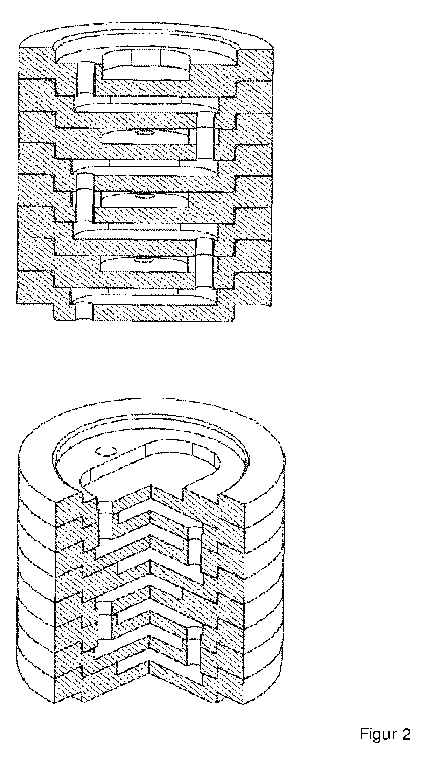

Wärmetauscher: Figur 2 zeigt einen typischen Wärmetauscher aus verschiedenen Elementen, die aus dem Material umfassend Graphit und Glas in verpresster Form bestehen.

## Patentansprüche

1. Verwendung eines Materials, umfassend Graphit und Glas als verpresste Mischung, als Reaktionsreaktor, Teil eines Reaktionsreaktors, als Wärmetauscher oder als Kühlkörper.

2. Verwendung nach Anspruch 1,wobei das Material Graphit in Mengen von 50 Gew.-% bis 80 Gew.-% und Glas in Mengen von 20 Gew.-% und 50 Gew.-% umfasst.

3. Verwendung nach Anspruch 1 oder zwei, wobei das Glas ausgewählt ist aus Borosilikatgläsern, Bleigläsern, Phosphatgläsern, Alkali-Gläsern, Erdalkaligläsern oder Kalk-Natron-Gläsern.

4. Verwendung nach einem der vorhergehenden Ansprüche, wobei Graphit als Mischung von synthetischem und natürlichem Graphit oder als reiner Naturgraphit vorliegt.

5. Verwendung nach Anspruch 4, wobei der Anteil an Naturgraphit im Graphit von 20 Gew.-% bis 100 Gew.-% beträgt.

6. Verwendung nach Anspruch 4, wobei der Anteil an synthetischem Graphit von bis zu 80 Gew.-% beträgt.

7. Verwendung nach einem der vorhergehenden Ansprüche, wobei die verpresste Mischung aus dem Verpressen von einem Gemisch aus Graphit- und Glaspulver hervorgegangen ist.

8. Verwendung nach Anspruch 7, wobei das Gemisch aus Graphit- und Glaspulver ein homogenes Gemisch ist.

9. Verwendung nach Anspruch 7, wobei das Verpressen unter erhöhten Temperaturen und im Vakuum durchgeführt wird.

10. Verwendung nach Anspruch 7, wobei das Verpressen bei einem Pressdruck von wenigstens 3 kN/cm² durchgeführt wird.

11. Verwendung nach Anspruch 7, wobei das Verpressen bei Temperaturen von größer 600°C durchgeführt wird.

12. Endkonturnahe Herstellung eines Formkörpers bestehend aus einem Material umfassend eine verpresste Mischung aus Graphit und Glas, mit den Schritten -
- Mischen von Graphit- und Glaspulver
- Einfüllen des Pulvergemisches in eine Pressform
- Erwärmen des Pulvergemisches auf Temperaturen von größer als 600°C
- Pressen bei einem Druck 3 kN/cm² im Vakuum bei 20 mbar oder kleiner.

13. Herstellung nach Anspruch 11, wobei die Pressform aus Graphit besteht.

14. Herstellung nach Anspruch 11 oder 12, wobei die Pressform die Gestalt des Negativs des herzustellenden Formkörpers aufweist.
